# FASCICULE DE BREVET EUROPEEN

(11) **EP 3 328 806 B1**
(45) Date de publication et mention de la délivrance du brevet: **06.05.2020**
(21) Numéro de dépôt: 16760525.2
(22) Date de dépôt: 27.07.2016
(51) Int. Cl.: H01L 31/0224, H01L 31/028, H01L 31/032, H01L 31/18, C03C 17/23

(54) **DOPAGE ÉLECTROSTATIQUE D'UNE COUCHE D'UN MATERIAU CONDUCTEUR OU NON-CONDUCTEUR**
ELEKTROSTATISCHE DOTIERUNG EINER SCHICHT EINES LEITENDEN ODER NICHTLEITENDEN MATERIALS
ELECTROSTATIC DOPING OF A LAYER OF A CONDUCTIVE OR NON-CONDUCTIVE MATERIAL

(30) Priorité: 30.07.2015 FR 1557308
(43) Date de publication de la demande: 06.06.2018
(73) Titulaire: Université Pierre et Marie Curie (Paris 6), 75005 Paris (FR); Centre National de la Recherche Scientifique, 75016 Paris (FR)
(72) Inventeur: SHUKLA, Abhay, 94240 L'Haye les Roses (FR); BISCARAS, Johan, 75013 Paris (FR); PARADISI, Andrea, 92120 Montrouge (FR)
(74) Mandataire: Goulard, Sophie
(86) Numéro de dépôt international: PCT/FR2016/051942
(87) Numéro de publication internationale: WO 2017/017372

(56) Documents cités:
- WO-A1-2015/143371
- US-A1- 2009 032 873
- US-A1- 2013 000 833
- US-B2- 7 176 528
- KARIM GACEM ET AL: "Paper;High quality 2D crystals made by anodic bonding: a general technique for layered materials;High quality 2D crystals made by anodic bonding: a general technique for layered materials", NANOTECHNOLOGY, IOP, BRISTOL, GB, vol. 23, no. 50, 29 novembre 2012 (2012-11-29), page 505709, XP020233974, ISSN: 0957-4484, DOI: 10.1088/0957-4484/23/50/505709
- WALLIS G ET AL: "FIELD ASSISTED GLASS-METAL SEALING", JOURNAL OF APPLIED PHYSICS, AMERICAN INSTITUTE OF PHYSICS, US, vol. 40, no. 10, 1 septembre 1969 (1969-09-01), pages 3946-3949, XP000601832, ISSN: 0021-8979, DOI: 10.1063/1.1657121

## Description

L'invention est relative à un procédé de dopage électrostatique permanent d'une couche d'un matériau conducteur ou non-conducteur déposé sur un substrat solide.

Les couches transparentes conductrices sont utilisées dans de nombreux dispositifs comme les écrans tactiles, les verres électrochromes ou les cellules photovoltaïques. Ces couches conductrices sont réalisées dans des matériaux conducteurs ou non-conducteurs et sont généralement dopées afin de modifier leurs propriétés électroniques et augmenter leur conductivité.

Le dopage modifie la conductivité du matériau conducteur ou non-conducteur en modifiant la densité des porteurs de charges dans le matériau. Les porteurs de charges d'un matériau sont, d'une part, les électrons et, d'autre part, les trous, c'est-à-dire les zones de déficit électronique.

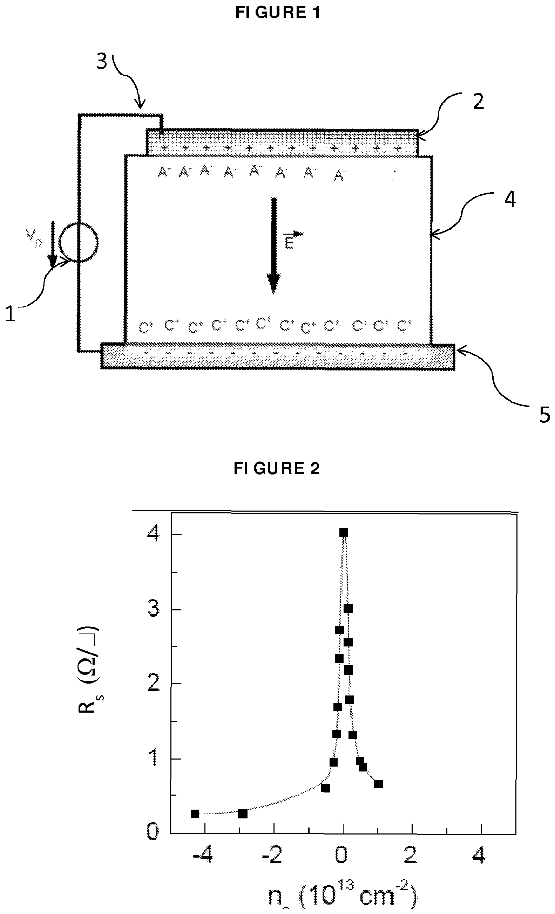

La méthode la plus courante pour modifier la densité des porteurs de charges d'un matériau conducteur ou non-conducteur est le dopage chimique qui consiste à introduire des impuretés, c'est-à-dire des atomes de la substance dopante, dans le matériau. Dans le cas où les impuretés sont riches en électrons, le dopage induit un excès d'électrons qui sont négativement chargés et est qualifié de dopage de type N. Dans le cas où les impuretés sont pauvres en électrons, le dopage induit un déficit d'électrons, c'est-à-dire un excès de trous considérés comme positivement chargés et est qualifié de dopage de type P. Cependant, le dopage chimique du matériau présente deux inconvénients majeurs. D'une part, cette technique n'est pas réversible et il est donc nécessaire de réaliser un nouvel échantillon si l'on veut modifier la nature ou l'intensité du dopage. D'autre part, la modification de la composition chimique peut entraîner une désorganisation du matériau dopé. Par ailleurs, le dopage chimique de certains matériaux comme le graphène n'est pas entièrement satisfaisant car il n'est pas stable dans le temps (Figure 2, Kim et al., Nanotechnology, 2010, 21, 285205).

Une autre méthode de modification de la densité des porteurs de charges est le dopage électrostatique. Cette méthode consiste à appliquer un champ électrique à une surface, en créant une différence de potentiel entre une une électrode et la surface, séparées par un isolant. C'est le principe du transistor à effet de champ qui a été utilisé avec succès pour doper les matériaux ultras minces (Ahn et al. Rev. Mod. Phys., 2006, 78, p1185-1212). Cependant le dopage est limité à des valeurs faibles en utilisant cette méthode car l'isolant, interface entre l'électrode et la surface à doper, a tendance à se dégrader au-delà de sa rigidité diélectrique quand le champ électrique augmente pour augmenter le dopage (création d'arc électrique dans le matériau : claquage).

Pour contourner cette limitation le dopage électrostatique a aussi été développé avec des procédés réalisés dans des liquides ioniques (voir par exemple Misra, R. et al., App. Phys. Lett., 2007, 90, 052905). Dans ce cas, le champ électrique est créé entre une couche d'ions dans l'électrolyte et la surface de l'électrode immergée dans l'électrolyte, qui est aussi la surface à doper. Bien que de tels procédés permettent d'atteindre des niveaux de dopage très haut, ils sont complexes à mettre en œuvre et ne peuvent pas être appliqués à tout type de matériau conducteur ou non-conducteur, car ils présupposent toujours un dispositif de type cellule électrochimique. De même la mise en œuvre de ces procédés peut générer des réactions électrochimiques qui transformeraient le caractère électrostatique du dispositif. De plus, ces procédés ne permettent pas de réaliser un dopage parfaitement contrôlé et réversible du matériau.

Il n'existe donc pas dans l'art antérieur de procédé permettant de doper de façon contrôlée et réversible une couche d'un matériau conducteur ou non-conducteur déposée sur un substrat et ce, à de très hauts niveaux de dopage.

En revanche, des méthodes de collage d'un matériau conducteur ou non-conducteur sur une matrice vitreuse sous l'influence d'un champ électrique sont décrites dans l'art antérieur. Ces méthodes utilisent les propriétés particulières des matrices vitreuses (ou verres). Les verres sont constitués d'oxydes « formateurs » formant à eux-seuls le squelette de la matrice vitreuse et d'oxydes « modificateurs » (ou « non-formateurs ») qui ne peuvent pas former de matrice vitreuse à eux-seuls. Parmi les oxydes formateurs figurent l'oxyde de silicium (SiO₂) qui est le constituant majoritaire des matrices vitreuses, ainsi que d'autres oxydes tels que l'oxyde de bore (B₂O₃), l'oxyde de phosphore (P₂O₅) et l'oxyde de germanium (GeO₂). Les oxydes modificateurs sont essentiellement les oxydes alcalins, alcalino-terreux et dans une moindre mesure certains oxydes d'éléments de transition ou de terres rares. Les oxydes alcalins, également appelés « fondants », sont utilisés pour abaisser la température de fusion de la matrice vitreuse. Ils comprennent notamment l'oxyde de sodium (Na₂O), l'oxyde de potassium (K₂O), et l'oxyde de lithium (Li₂O). D'autres oxydes, également appelés « stabilisants » sont utilisés pour modifier les propriétés physiques et/ou mécaniques de la matrice vitreuse généralement atténuées par l'adjonction des fondants. Ils comprennent les oxydes alcalino-terreux comme l'oxyde de calcium (CaO) qui augmente la résistance chimique du verre, l'oxyde de zinc (ZnO) qui augmente l'éclat et l'élasticité du verre, l'oxyde de fer (Fe₂O₃) qui est la fois un stabilisant et un colorant et l'oxyde de plomb (PbO) qui entre dans la composition du cristal et qui abaisse également le point de fusion en stabilisant la composition vitreuse.

Le verre est un isolant à une température dite d'utilisation et peut devenir conducteur à une température plus élevée. En effet, alors que les atomes constituant les oxydes formateurs sont liés entre eux pour former le squelette de la matrice vitreuse, les oxydes modificateurs sont quant à eux répartis au sein de la matrice vitreuse sans être liés aux oxydes formateurs. Ainsi, lors d'une élévation de la température de la matrice vitreuse les ions des oxydes modificateurs présents dans la matrice vitreuse ont la particularité de devenir mobiles, la matrice vitreuse devenant alors ioniquement conductrice.

Ainsi, Wallis *et al.* décrivent la fixation d'une couche d'un matériau tel que le silicium sur une matrice vitreuse selon un procédé consistant à soumettre l'ensemble matrice vitreuse/matériau à une température de 300°C à 600°C puis à appliquer un champ électrique de 200 V à 2000 V, entraînant la création d'une liaison anodique entre la couche de silicium et la matrice vitreuse par des interactions électrostatiques (Wallis, G., et al., I. J. Appl. Phys., 1969, 40 (10), p 3946-3949).

La demande internationale WO2009/074755 décrit également un procédé de fixation d'un matériau lamellaire au moins partiellement conducteur, en particulier le graphène, sur un substrat de type verre par l'utilisation des propriétés de conduction ionique du verre. Une électrode est placée sur le substrat de verre et une deuxième électrode est placée sur le matériau lamellaire. Le procédé est réalisé à l'air, à pression atmosphérique et à des températures élevées allant de 150°C à 350°C. L'application d'un champ électrique de 1,2 kV à 2 kV entre les deux électrodes conduit à la fixation du matériau lamellaire sur le substrat de verre. La surface de matériau lamellaire fixée est de l'ordre de 5000 µm² dans le cas du graphène. Selon ce procédé, seules les lamelles directement en contact avec le substrat, c'est à dire d'une épaisseur de quelques atomes, sont collées. Les lamelles qui ne sont pas en contact direct avec le substrat peuvent être éliminées, par exemple par pelage. Cependant, ce procédé ne permet pas le dopage du matériau fixé et encore moins un dopage contrôlé et réversible.

La demande de brevet US 2009/032873 décrit également un procédé de collage d'une couche ultra-mince d'un matériau semi-conducteur monocristallin sur une matrice vitreuse mettant en œuvre une étape d'électrolyse combinée à une exfoliation liée à l'implantation d'ions préalables. Cette méthode repose sur la présence d'une zone de déplétion d'ions alcalins pour former une liaison entre ledit matériau semi-conducteur et la matrice vitreuse. Ce procédé de collage ne permet cependant pas de modifier le degré de dopage intrinsèque du matériau semi-conducteur.

Il existe donc un besoin pour un procédé simple à mettre en œuvre et permettant de doper un matériau conducteur ou non-conducteur de façon permanente, contrôlée et réversible.

L'invention a donc pour objet un procédé de dopage électrostatique contrôlé et réversible d'un matériau conducteur ou non-conducteur déposé sous forme d'une couche sur un substrat solide, ledit matériau étant choisi dans le groupe comprenant le graphène, le disulfure de molybdène (MoS₂), le disulfure de tungstène (WS₂), le séléniure d'indium (InSe), le sulfure de gallium (GaS), l'oxyde de zinc (ZnO), l'oxyde d'indium dopé à l'étain (ITO) et les cuprates supraconducteurs, ledit procédé étant caractérisé en ce qu'il est réalisé sous vide, que ledit substrat est une matrice vitreuse contenant des ions mobiles à une température de dopage (T_{D}) allant de 50°C à 130°C, et en ce qu'il comprend au moins les étapes suivantes :
- porter ladite matrice vitreuse comportant ladite couche de matériau conducteur ou non-conducteur à ladite température de dopage,
- appliquer un champ électrique entre ladite matrice vitreuse et ledit matériau conducteur ou non-conducteur à une tension allant de -300 V à +300 V, tout en maintenant la température à la température de dopage,
- porter ladite matrice vitreuse comportant ladite couche de matériau conducteur ou non-conducteur à une température d'utilisation (T_{U}), ladite température d'utilisation étant inférieure à 50°C,
ledit procédé étant réalisé sur au moins une partie de la surface dudit matériau conducteur ou non-conducteur.

La matrice vitreuse utilisée à titre de substrat solide selon le procédé de l'invention peut être choisie parmi les verres inorganiques tels que les verres sodocalciques, les verres borosilicatés ou tout autre verre pourvu de conductivité ionique
Selon un mode de réalisation préféré, la matrice vitreuse utilisée est une matrice en verre sodocalcique ou borosilicaté.

Le matériau à doper est un matériau conducteur ou non-conducteur dont la conductivité est augmentée par le dopage c'est-à-dire sous l'effet du champ électrique appliqué entre le matériau conducteur ou non-conducteur et une électrode placée sur l'autre surface du substrat que constitue la matrice vitreuse.

Le matériau conducteur ou non-conducteur doit être déposé sur la matrice vitreuse.

Selon un mode de réalisation préféré, le matériau conducteur ou non-conducteur est choisi parmi le graphène, le disulfure de molybdène (MoS₂) et l'oxyde de zinc (ZnO).

L'épaisseur de la couche du matériau conducteur ou non-conducteur déposé sur la matrice vitreuse peut être quelconque mais l'épaisseur du matériau dopé à l'interface matériau-verre varie entre l'épaisseur atomique et quelques nanomètres.

Selon l'invention, l'expression « une épaisseur de quelques nanomètres » signifie une épaisseur de 1 à 100 nanomètres environ, et encore plus préférentiellement de 1 à 10 nm environ.

La surface de la matrice vitreuse est de préférence polie et propre pour assurer un bon contact avec la couche de matériau conducteur ou non-conducteur à déposer.

Le procédé de dopage électrostatique est réalisé sous vide, de préférence à une pression inférieure à 10⁻³ mbar environ. En effet, les conditions atmosphériques peuvent avoir une influence sur la qualité du dopage et en particulier, les molécules de gaz environnant peuvent entraîner une dépolarisation du matériau dopé.

Le procédé de dopage électrostatique est basé sur la mobilité des ions présents dans la matrice vitreuse, en particulier des cations tels que Na⁺ et Li⁺, sous l'effet du champ électrique appliqué entre la matrice vitreuse et la couche de matériau conducteur ou non-conducteur, à une température donnée. En effet, lorsque la température de la matrice vitreuse est supérieure ou égale à 50°C, les ions présents dans la matrice vitreuse sont mobiles et peuvent migrer sous l'effet du champ électrique. D'une manière générale, la mobilité des ions augmente en fonction de la température. Ainsi, dans la gamme de température de dopage (T_{D}), les ions sont mobiles et migrent sous l'effet du champ électrique. Au contraire, à la température d'utilisation (T_{U}), les ions présents dans la matrice vitreuse ne sont plus mobiles même en présence d'un champ électrique. Les matrices vitreuses utilisées selon le procédé conforme à l'invention ont une température d'utilisation inférieure à la température de dopage.

Selon une forme de réalisation préférée du procédé conforme à l'invention, la température de dopage varie de 65°C à 130°C environ, et encore plus préférentiellement de 80°C à 130°C environ.

L'application du champ électrique peut être obtenue en connectant d'une part ladite couche de matériau conducteur ou non-conducteur et d'autre part la matrice vitreuse à une source de tension électrique, respectivement au moyen d'une première et d'une deuxième électrodes, par exemple selon le schéma présenté à la figure 1. Sur cette figure, la source de tension électrique 1 est connectée, d'une part, au matériau conducteur ou non-conducteur 2 par l'intermédiaire d'une première électrode 3 et, d'autre part, à la matrice vitreuse 4 par l'intermédiaire d'une deuxième électrode 5.

La source de tension électrique est connectée d'une part à la face dite « avant » de l'ensemble matrice vitreuse/matériau conducteur qui est la face comportant la couche de matériau à doper déposé sur la matrice vitreuse et, d'autre part, à la face dite « arrière » dudit ensemble, qui est la face opposée de la matrice vitreuse.

Selon un premier mode de réalisation, le matériau conducteur ou non-conducteur est dit fin et/ou lamellaire avec une épaisseur inférieure à 100 nanomètres. Dans ce cas, la connexion de la face avant est de préférence réalisée par l'intermédiaire d'un circuit métallique déposé en partie sur le matériau à doper et en partie sur la matrice vitreuse. Un matériau fin peut être par exemple choisi parmi les matériaux lamellaires comme le graphène ou le MoS₂. Selon ce mode de réalisation, des méthodes conventionnelles de création d'un circuit métallique peuvent être utilisées comme par exemple la lithographie optique ou électronique ou la technique d'évaporation à travers un masque. Dans ce mode de réalisation, le circuit métallique est constitué d'un ou plusieurs métal(aux) qui peu(ven)t être choisi(s) en fonction du matériau à doper, comme le chrome et l'or pour le graphène ou le titane et l'or pour le MoS₂.

Selon un second mode de réalisation, le matériau conducteur ou non-conducteur est épais et/ou polycristallin, c'est à dire qu'il a une épaisseur supérieure à 100 nm, et peut être constitué de plusieurs cristaux. Dans ce cas, la connexion de la face avant peut être réalisée plus simplement en plaçant une pointe métallique connectée à la source de tension directement sur le matériau conducteur ou non-conducteur. La connexion peut, par exemple, se faire grâce à une pointe de microscope en champ proche dans le cas du dopage local invoqué ci-dessous. Selon ce mode de réalisation, le matériau à doper épais et polycristallin peut être choisi parmi les oxydes de métaux comme le ZnO.

La source de tension est également connectée à la face arrière de la matrice vitreuse à l'aide, par exemple, d'une électrode métallique. Le contact entre la face arrière de la matrice vitreuse et l'électrode peut se faire en posant directement la matrice vitreuse sur l'électrode ou en maintenant la matrice vitreuse contre l'électrode par une cale. Le contact peut également être réalisé en utilisant un adhésif conducteur, par exemple de la laque d'argent, ou par évaporation d'un métal.

Selon un mode de réalisation, la connexion entre la source de tension électrique et l'ensemble matrice vitreuse/matériau est réalisée à la température d'utilisation et l'ensemble matrice vitreuse/matériau à doper/circuit électrique est ensuite porté à la température de dopage.

Selon un autre mode de réalisation, l'ensemble matrice vitreuse/matériau est porté à la température de dopage puis le circuit électrique est mis en place.

Par convention, le matériau conducteur ou non-conducteur est considéré comme ayant un potentiel nul. Un potentiel électrique de dopage (V_{D}) est appliqué entre l'électrode en contact avec le matériau conducteur ou non-conducteur (première électrode) et l'électrode en contact avec la face arrière de la matrice vitreuse (deuxième électrode).

Selon un premier mode de réalisation particulier, le potentiel électrique appliqué sur la deuxième électrode est positif par rapport au potentiel de la première électrode. Dans ce cas, la deuxième électrode est alors l'électrode à plus haut potentiel et les cations de la matrice vitreuse migrent en direction de la première électrode, s'accumulant ainsi près de l'interface entre la matrice vitreuse et le matériau conducteur ou non-conducteur. La proximité des charges positives près de l'interface entraîne la migration des électrons du matériau conducteur ou non-conducteur vers l'interface. Selon ce mode de réalisation, le procédé de dopage de l'invention est un procédé de dopage de type N.

Selon un deuxième mode de réalisation particulier, le potentiel électrique appliqué sur la deuxième électrode est négatif par rapport au potentiel de la première électrode. Dans ce cas, la première électrode est l'électrode à plus haut potentiel et les cations de la matrice vitreuse migrent vers la face arrière de la matrice vitreuse, à l'opposé du matériau conducteur ou non-conducteur. Une zone de déplétion de cations, appelée zone de charge d'espace, est donc créée dans la matrice vitreuse à proximité de l'interface avec le matériau conducteur ou non-conducteur, entrainant la migration des électrons du matériau conducteur ou non-conducteur à l'opposé de l'interface. Selon ce mode de réalisation, une zone de trous est donc créée dans le matériau à proximité de l'interface. Selon ce mode de réalisation, le procédé de dopage de l'invention est un procédé de dopage de type P. La vitesse de migration des ions dépend de la valeur absolue de la tension appliquée. La durée pendant laquelle on applique la tension détermine la quantité de charges qui migrent et ainsi le niveau de dopage induit.

Selon un autre mode de réalisation, la matrice vitreuse contient des ions positifs et négatifs qui migrent dans des directions opposées sous l'effet du champ électrique. Selon ce mode de réalisation, la zone de charge d'espace est créée au niveau de l'interface matrice vitreuse/matériau conducteur ou non-conducteur soit par l'accumulation des charges négatives, soit par l'accumulation des charges positives.

D'une manière générale, une tension V_{D} positive crée une zone de charge d'espace positive qui dope le matériau en électrons (dopage de type N). Une tension V_{D} négative crée une zone de charge d'espace négative qui dope le matériau en trous (dopage de type P).

Selon le procédé de l'invention, la tension peut être appliquée à une valeur constante ou, au contraire, de façon progressive. La façon d'appliquer la tension dépend du niveau de dopage souhaité et la variation en cours du dopage, des propriétés diélectriques du matériau à doper.

La tension du champ électrique appliqué pour effectuer le dopage selon le procédé de l'invention varie de préférence de -100 V à +100 V, environ.

Lorsque le matériau à doper a atteint le niveau de dopage voulu, la polarisation est figée par un refroidissement rapide de l'ensemble matrice vitreuse/matériau conducteur ou non-conducteur à la température T_{U}, soit par simple arrêt de chauffage, soit par l'arrêt de chauffage combiné avec refroidissement par fluide cryogénique. A cette température d'utilisation, la mobilité des ions est considérée comme nulle et les ions sont donc figés. La zone de charge d'espace dopant le matériau est donc également figée. A la température d'utilisation, la tension de dopage et les électrodes métalliques peuvent être enlevées sans que les ions ne migrent. Le dopage électrostatique est donc permanent à condition que la couche dopée ne subisse pas de processus de dépolarisation, par exemple par contact avec des molécules polarisables.

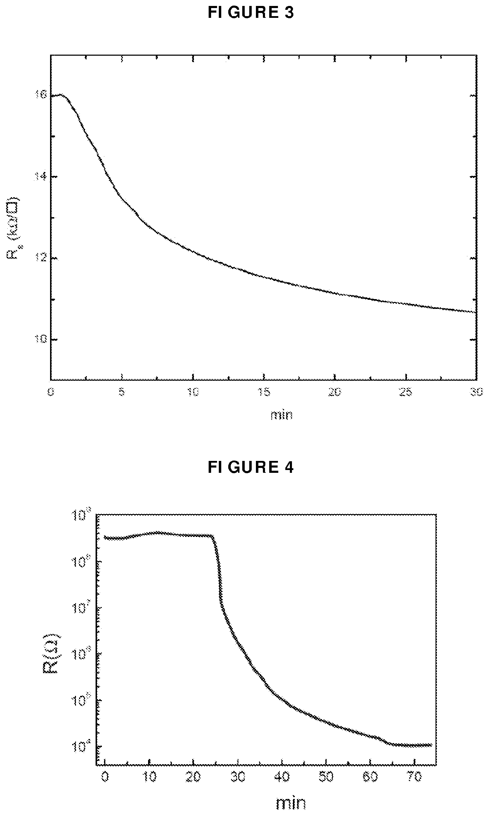

La durée d'application du champ électrique varie en fonction de l'intensité du dopage souhaité qui lui-même dépend du type de verre utilisé (teneur en ions), de la température et de la valeur absolue du champ. Typiquement, la durée d'application du champ électrique peut varier de 1 minute à quelques heures, et par exemple 2 heures pour atteindre le niveau de dopage maximal dans le graphène (Figure 4).

De façon avantageuse, le dopage est modifiable. En effet, il suffit de replacer l'ensemble matrice vitreuse/matériau dopé à la température de dopage afin de rendre les ions mobiles et d'appliquer une tension pour, par exemple, renforcer le dopage, l'inverser ou l'annuler.

Le dépôt de la couche de matériau conducteur ou non-conducteur sur la matrice vitreuse peut être réalisé par des méthodes connues de l'art antérieur comme les dépôts par voie chimique, par voie physique, par le dépôt de cristaux fraîchement clivés, ou par collage anodique. Dans le cas où le matériau à doper est le graphène ou le MoS₂, le dépôt peut, par exemple, être réalisé par la méthode d'exfoliation au ruban adhésif, par méthode CVD (« *chemical vapor déposition* »), par transfert en voie humide ou voie sèche (« *wedging* » *ou* « *dry transfer* ») ou par liaison anodique. Lorsque le matériau à doper est un oxyde tel que l'oxyde de zinc (ZnO), le dépôt peut, par exemple, être réalisé par un procédé sol-gel, par évaporation thermique, par méthode CVD, ablation laser pulsé (PLD) ou pulvérisation.

Selon un mode de réalisation préféré, la matrice vitreuse est du verre borosilicaté et le matériau conducteur ou non-conducteur est le graphène.

Selon un autre mode de réalisation préféré, la matrice vitreuse est du verre borosilicaté et le matériau conducteur ou non-conducteur est le disulfure de molybdène.

Selon un autre mode de réalisation préféré, la matrice vitreuse est du verre sodocalcique et le matériau conducteur ou non-conducteur est l'oxyde de zinc.

La valeur du dopage peut être mesurée durant le procédé de dopage ou, à la température d'utilisation, une fois le dopage effectué. Durant le dopage, la mesure peut être réalisée directement en fonction de la tension délivrée qui est proportionnelle à la quantité de charges qui se déplacent dans la matrice vitreuse et, donc, à la valeur du dopage induit dans le matériau. La valeur du dopage peut également être évaluée par des méthodes de spectroscopies optiques infra-rouge ou Raman qui permettent de quantifier le dopage en fonction de variation de certaines lignes spectrales. Dans le cas où plusieurs contacts électriques sont disposés sur le matériau conducteur ou non-conducteur, en géométrie de barre de Hall ou Van der Pauw par exemple, le dopage peut être mesuré par effet Hall en appliquant un champ magnétique.

Selon un mode de réalisation, il est possible de réaliser un dopage localisé en appliquant un ou plusieurs point(s) de tension sur la surface du matériau. En effet, si le matériau est non-conducteur, une pointe fine en contact avec une région localisée dans le matériau induira un changement de dopage seulement au voisinage de la pointe.

Selon un autre mode de réalisation et par extension du dopage local envisagé ci-dessus, il est possible de créer un gradient de dopage en appliquant des points de tensions différentes à différents endroits de la surface du matériau non-conducteur. Un gradient peut, par exemple, être réalisé pour créer une jonction entre une zone dopée en électrons et une zone dopée en trous.

Une fois le dopage effectué, différents paramètres peuvent être mesurés, en particulier, la densité des porteurs de charges dans la couche de matériau conducteur ou non-conducteur, la différence entre la résistance surfacique du matériau avant et après dopage (ΔRs), la transparence du matériau dopé en pourcentage par rapport à la transparence du matériau avant dopage.

La densité des porteurs de charges et le type de dopage (N ou P) peuvent être mesurés grâce aux techniques citées ci-dessus et notamment grâce aux mesures de l'effet Hall. La densité des porteurs de charges induites peut atteindre jusqu'à 10¹⁵ cm⁻² environ.

La différence de résistance surfacique du matériau (ΔRs) et la transparence du matériau dopé avant et après dopage peuvent être mesurée par des techniques appropriées et bien connues de l'homme du métier. Ces valeurs dépendent clairement du matériau et du niveau de dopage. Pour la monocouche de graphène CVD, le procédé conforme à l'invention permet d'atteindre des résistances surfaciques inférieures à 200 Ohms/carrée avec une transparence non dégradée par rapport au matériau non-dopé, c'est à dire de 97% pour un niveau de dopage de 5. 10¹³ cm⁻².

Un contrôle par spectroscopie optique Raman permet également de vérifier que le dopage n'a pas introduit de défaut dans le matériau conducteur ou non-conducteur.

Le matériau conducteur ou non-conducteur dopé obtenu selon le procédé selon l'invention, se présente sous la forme d'une couche d'un matériau conducteur ou non-conducteur dopé supporté par une matrice vitreuse, une zone de charges d'espace étant présente sur au moins une partie de l'interface matrice vitreuse/matériau conducteur ou non-conducteur dopé.

Les caractéristiques du matériau conducteur ou non-conducteur dopé obtenu selon le procédé de l'invention, et, notamment, celles de la matrice vitreuse utilisée, du matériau conducteur ou non-conducteur utilisé, l'épaisseur et la surface du matériau conducteur ou non-conducteur, les associations préférées de matrice vitreuse et matériau conducteur ou non-conducteur, ainsi que les paramètres de densité de porteurs de charges, de différence de résistance surfacique du matériau avant et après dopage (ΔRs), la transparence et les défauts du matériau, sont telles que définies dans le premier objet de l'invention.

Selon une forme de réalisation préférée de l'invention, la densité des porteurs de charges dans la zone de charges d'espaces à l'interface matrice vitreuse/matériau conducteur ou non-conducteur dopé varie de - 10¹⁵ cm⁻² à + 10¹⁵ cm⁻².

Selon l'invention, ledit matériau conducteur ou non-conducteur obtenu à l'issue du procédé de dopage conforme à l'invention, est donc un matériau dopé exclusivement par action électrostatique de la zone de charges d'espace résultant d'une accumulation des cations présents dans la matrice vitreuse (zone de charges positives) ou d'une déplétion en lesdits cations (zone de charges négatives) au niveau d'au moins une partie de l'interface matrice vitreuse/matériau conducteur ou non conducteur.

Selon un mode de réalisation, la zone de charges d'espace présente sur au moins une partie de l'interface matrice vitreuse/matériau conducteur ou non-conducteur dopé est positive (zone d'accumulation en cations), et le dopage est de type N. Dans ce cas, la densité des porteurs de charge varie de préférence de -10¹⁰ cm⁻² à -10¹⁵ cm⁻² environ, et encore plus préférentiellement de -10¹² cm⁻² à -10¹⁴ cm⁻².

Selon un autre mode de réalisation, la zone de charges d'espace présente sur au moins une partie de l'interface matrice vitreuse/matériau conducteur ou non-conducteur dopé est négative (zone de déplétion en cations), et le dopage est dit de type P. Dans ce cas, la densité des porteurs de charge varie de préférence de + 10¹⁰ cm⁻² à + 10¹⁵ cm⁻², et encore plus préférentiellement de + 10¹² cm⁻² à + 10¹⁴ cm⁻².

Le matériau conducteur ou non-conducteur dopé obtenu selon le procédé de l'invention et tel que défini précédemment, peut être utilisé dans des systèmes requérant une électrode transparente, des dispositifs à base de semi-conducteurs ou des dispositifs contenant un supraconducteur induit par dopage.

Selon un mode de réalisation préféré, le matériau conducteur ou non-conducteur est du graphène, la matrice vitreuse est du verre borosilicaté ou sodocalcique et le matériau conducteur ou non-conducteur dopé obtenu selon le procédé de l'invention peut être utilisé pour la fabrication d'écrans tactiles ou de cellules photovoltaïques.

Selon un autre mode de réalisation préféré, le matériau conducteur ou non-conducteur est du ZnO, la matrice vitreuse est du verre sodocalcique et le matériau conducteur ou non-conducteur dopé obtenu selon le procédé de l'invention peut être utilisé pour la fabrication de verres électrochromes.

Les exemples et figures suivants illustrent l'invention plus en détails sans toutefois en limiter la portée.
- La figure 1 représente le dispositif pour doper un matériau conducteur ou non conducteur (2) déposé sur une face d'un substrat de verre inorganique (4), une source de tension (1) connectée au matériau conducteur ou non-conducteur par une électrode (3) et à la matrice vitreuse sur l'autre face par une autre électrode (5).
- La figure 2 représente le dopage d'une couche de graphène en fonction du temps vu à travers la variation de sa résistance surfacique;
- La figure 3 représente le dopage d'une couche de disulfure de molybdène en fonction du temps vu à travers la variation de sa résistance surfacique;
- La figure 4 représente le dopage d'une couche d'oxyde de zinc en fonction du temps vu à travers la variation de sa résistance surfacique;
- La figure 5 représente un exemple comparatif d'un dopage effectué sous vide avec un dopage effectué à l'air, vu à travers la variation de la résistance surfacique.

### EXEMPLES

### EXEMPLE 1 : Dopage d'une couche de graphène sur du verre borosilicate selon le procédé conforme à l'invention

Le procédé de dopage a été réalisé en utilisant une monocouche de graphène CVD (« *chemical vapor déposition* ») sur feuille de cuivre commerciale (Graphene Supermarket, graphene-supermarket.com) déposée sur du verre borosilicate d'une épaisseur de 0,5 mm. Le dépôt a été réalisé par la méthode de transfert par poly-méthylméthacrylate (d'après la méthode explicitée par X. Li et al. Nano Lett., 2009, 9, 4359). L'ensemble a été relié à une source de tension par des électrodes, l'une étant en contact avec le graphène (Chrome/Or ; épaisseurs respectives 2 nm / 70 nm, évaporées thermiquement à travers un masque) et l'autre étant en contact avec la matrice vitreuse (laque d'argent). L'ensemble a alors été placé sous vide poussé à une pression inférieure à 10⁻⁶ mbar et a été porté à une température de 142°C. Une tension de 285 V a été appliquée durant 100 min. La méthode de Van der Pauw (van der Pauw, L.J. (1958) Philips Research Reports 13: 1-9) a été utilisée pour mesurer la résistivité du matériau, le type de dopage (N ou P) et la densité de porteurs de charges.
- Changement de résistance surfacique du matériau, ΔRs = -609 Ω/carré (figure 2)
- Densité de porteurs de charge : N = 4,4 x 10¹³ cm⁻²
- Transparence = 97 % à 550 nm

### EXEMPLE 2 : Dopage d'une couche de disulfure de molybdène sur du verre borosilicaté selon le procédé conforme à l'invention

Le dopage a été réalisé selon le procédé de l'exemple 1, sur un échantillon de MoS₂ de 2 nm d'épaisseur déposé par collage anodique en utilisant un échantillon comprenant une couche de disulfure de molybdène, d'une surface de 50 µm², déposée sur une matrice de verre borosilicaté d'une épaisseur de 0,5 mm. L'échantillon a été placé sous vide à une pression de 10⁻⁶ mbar puis porté à une température de 130°C. Une tension de +4 V a été appliquée durant 30 minutes.
- Changement de résistance surfacique du matériau, ΔRs = -5 kΩ/carré (figure 3)
- Densité de porteurs de charge : N = 10¹³ cm⁻²

### EXEMPLE 3 : Dopage d'une couche d'oxyde de zinc sur du verre selon le procédé conforme à l'invention.

Le dopage a été réalisé en utilisant un échantillon comprenant une couche d'oxyde de zinc de 25 nm d'épaisseur, d'une surface de 1 mm² déposée par pulvérisation RF (Radio Fréquence) sur une matrice de verre sodocalcique d'une épaisseur de 0,5 mm. L'échantillon a été placé sous vide à une pression de 10⁻⁶ mbar puis porté à une température de 130°C. Une tension de +35 V a été appliquée durant 70 minutes.
- Changement de résistance surfacique du matériau, ΔRs diminue de quatre ordres de grandeur, de 10⁸ à 10⁴ kΩ/carrée (figure 4)
- Densité de porteurs de charge : N = 10¹⁴ cm⁻²
- Transparence = 92 % à 550 nm

### Exemple 4 : Exemple comparatif entre un procédé effectué à l'air et un dopage effectué sous vide

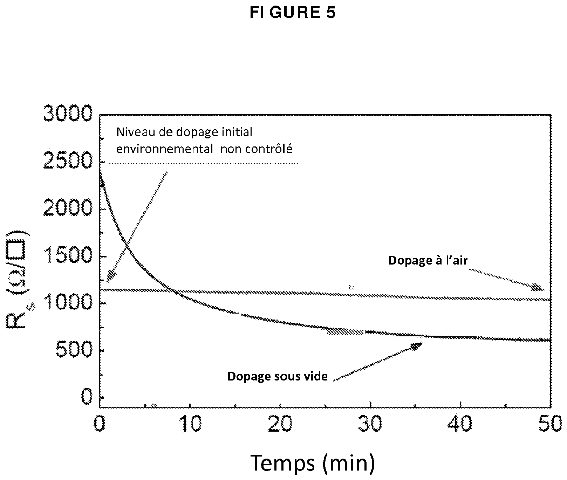

Dans cet exemple, le procédé a réalisé en utilisant deux échantillons identiques 1 et 2 comprenant une couche de graphène de 0,4 nm d'épaisseur sur une matrice de verre borosilicaté d'une épaisseur de 0,5 mm. L'échantillon 1 a été placé sous vide à une pression de 10⁻⁶ mbar puis porté à une température de 71°C. Une tension de -190 V a été appliquée durant 120 minutes. L'échantillon 2 a été laissé à l'air puis porté à une température de 145°C. Une tension de -200V a été appliquée durant 120 minutes.
- Changement de résistance surfacique de l'échantillon 1, ΔRs = 0,65 kΩ/carrée (courbe sensiblement horizontale, figure 5)
- Changement de résistance surfacique de l'échantillon 2, ΔRs = -0,06 kΩ/carrée (courbe incurvée, figure 5)

Les résultats de dopage obtenus pour chacun des échantillons 1 et 2 comparatifs sont donnés dans la figure 5 annexée. Ces résultats montrent que lorsque le procédé est réalisé à l'air à pression atmosphérique (Echantillon 1 : courbe sensiblement horizontale) et non sous vide (Echantillon 2 : courbe incurvée), aucun dopage n'est obtenu.

## Revendications

1. Procédé de dopage électrostatique contrôlé et réversible d'un matériau conducteur ou non-conducteur déposé sous forme de couche sur un substrat solide, ledit matériau étant choisi dans le groupe comprenant le graphène, le disulfure de molybdène, le disulfure de tungstène, le séléniure d'indium, le sulfure de gallium, l'oxyde de zinc, l'oxyde d'indium dopé à l'étain et les cuprates supraconducteurs, ledit procédé étant **caractérisé en ce qu'**il est réalisé sous vide, que ledit substrat est une matrice vitreuse contenant des ions mobiles à une température de dopage (T_{D}) allant de 50 °C à 130°C, et **en ce qu'**il comprend au moins les étapes suivantes :
- porter ladite matrice vitreuse comportant ladite couche de matériau conducteur ou non-conducteur à ladite température de dopage ,
- appliquer un champ électrique entre ladite matrice vitreuse et ledit matériau conducteur ou non-conducteur à une tension allant de -300 V à +300 V, tout en maintenant la température à la température de dopage,
- porter ladite matrice vitreuse comportant ladite couche de matériau conducteur ou non-conducteur à une température d'utilisation (Tu), ladite température d'utilisation étant inférieure à 50°C,
ledit procédé étant réalisé sur au moins une partie de la surface dudit matériau conducteur ou non-conducteur.

2. Procédé selon la revendication 1, **caractérisé en ce que** le matériau conducteur ou non-conducteur est choisi parmi le graphène, le disulfure de molybdène et l'oxyde de zinc.

3. Procédé selon la revendication 2 ou 3, **caractérisé en ce que** l'épaisseur du matériau dopé à l'interface matériau-verre varie entre l'épaisseur atomique et quelques nanomètres.

4. Procédé selon l'une quelconque des revendications précédentes, **caractérisé en ce qu'**il est réalisé à une pression inférieure à 10⁻³ mbar.

5. Procédé selon l'une quelconque des revendications précédentes, **caractérisé en ce que** la température de dopage varie de 65°C à 130°C.

6. Procédé selon l'une quelconque des revendications précédentes, **caractérisé en ce que** l'application du champ électrique est obtenue en connectant d'une part ladite couche de matériau conducteur ou non-conducteur et d'autre part la matrice vitreuse à une source de tension électrique, respectivement au moyen d'une première et d'une deuxième électrode.

7. Procédé selon la revendication 6, **caractérisé en ce que** le dopage est un dopage de type N et que le potentiel électrique appliqué sur la deuxième électrode est positif par rapport au potentiel de la première électrode.

8. Procédé selon la revendication 6, **caractérisé en ce que** le dopage est un dopage de type P et que le potentiel électrique appliqué sur la deuxième électrode est négatif par rapport au potentiel de la première électrode.

## Patentansprüche

1. Verfahren zur gesteuerten und reversiblen elektrostatischen Dotierung eines leitenden oder nicht leitenden Materials, das in Form einer Schicht auf einem festen Substrat abgelegt ist, wobei das Material ausgewählt ist aus der Gruppe, umfassend Graphen, Molibdändisulfid, Wolframdisulfid, Indiumselenid, Galliumsulfid, Zinkoxid, Indiumoxid, dotiert mit Zinn und den supraleitenden Cupraten, wobei das Verfahren **dadurch gekennzeichnet ist, dass** es unter Vakuum durchgeführt wird, dass das Substrat eine Glasmatrix ist, enthaltend bewegliche Ionen bei einer Dotierungstemperatur (T_{D}), die von 50 °C bis 130 °C reicht, und dadurch, dass es mindestens die folgenden Schritte umfasst:
- Bringen der Glasmatrix, umfassend die Schicht aus leitendem oder nicht leitendem Material, auf die Dotierungstemperatur,
- Anwenden eines elektrischen Felds zwischen der Glasmatrix und dem leitenden oder nicht leitenden Material mit einer Spannung, die von -300 V bis +300 V reicht, wobei gleichzeitig die Temperatur bei der Dotierungstemperatur gehalten wird,
- Bringen der Glasmatrix, umfassend die Schicht aus leitendem oder nicht leitendem Material, auf eine Verwendungstemperatur (T_{U}),
wobei die Verwendungstemperatur niedriger als 50 °C ist, wobei das Verfahren auf mindestens einem Teil der Oberfläche des leitenden oder nicht leitenden Materials durchgeführt wird.

2. Verfahren nach Anspruch 1, **dadurch gekennzeichnet, dass** das leitende oder nicht leitende Material ausgewählt ist aus Graphen, Molibdändisulfid und Zinkoxid.

3. Verfahren nach Anspruch 2 oder 3, **dadurch gekennzeichnet, dass** die Dicke des dotierten Materials an der Schnittstelle Material-Glas zwischen der Atomdicke und einigen Nanometern variiert.

4. Verfahren nach einem der vorhergehenden Ansprüche, **dadurch gekennzeichnet, dass** es bei einem Druck von weniger als 10⁻³ mbar durchgeführt wird.

5. Verfahren nach einem der vorhergehenden Ansprüche, **dadurch gekennzeichnet, dass** die Dotierungstemperatur von 65 °C bis 130 °C variiert.

6. Verfahren nach einem der vorhergehenden Ansprüche, **dadurch gekennzeichnet, dass** die Anwendung des elektrischen Felds durch die Verbindung einerseits der Schicht aus leitendem oder nicht leitendem Material und andererseits der Glasmatrix mit einer Quelle elektrischer Spannung mit Hilfe einer ersten bzw. zweiten Elektrode erhalten wird.

7. Verfahren nach Anspruch 6, **dadurch gekennzeichnet, dass** die Dotierung eine Dotierung vom Typ N ist, und dass das elektrische Potenzial das auf die zweite Elektrode angewendet wird, mit Bezug auf das Potenzial der ersten Elektrode positiv ist.

8. Verfahren nach Anspruch 6, **dadurch gekennzeichnet, dass** die Dotierung eine Dotierung vom Typ P ist, und dass das elektrische Potenzial, das auf die zweite Elektrode angewendet wird, mit Bezug auf das Potenzial der ersten Elektrode negativ ist.

## Claims

1. Controlled, reversible electrostatic method for doping a conductive or non-conductive material deposited in the form of a layer on a solid substrate, said material being selected from the group comprising graphene, molybdenum disulfide, tungsten disulfide, indium selenide, gallium sulfide, zinc oxide, tin-doped indium oxide and cuprate superconductors, said method being **characterized in that** it is performed in a vacuum, **in that** said substrate is a glassy matrix containing ions mobile at a doping temperature (T_{D}) in the range of 50 °C to 130 °C, and **in that** it comprises at least the following steps:
- bringing said glassy matrix comprising said layer of conductive or non-conductive material to said doping temperature;
- applying an electric field between said glassy matrix and said conductive or non-conductive material at a voltage in the range of -300 V to +300V, whilst holding the temperature at the doping temperature;
- bringing said glassy matrix comprising said layer of conductive or non-conductive material to a temperature of use (T_{U}), said temperature of use being lower than 50 °C,
said method being implemented on at least one portion of the surface of said conductive or non-conductive material.

2. The method according to claim 1, **characterized in that** the conductive or non-conductive material is selected from among graphene, molybdenum disulfide and zinc oxide.

3. The method according to claim 2 or 3, **characterized in that** the thickness of the doped material at the material-glass interface varies between atomic thickness and a few nanometres.

4. The method according to any of the preceding claims, **characterized in that** it is implemented at a pressure lower than 10⁻³ bar.

5. The method according to any of the preceding claims, **characterized in that** the doping temperature varies between 65 °C and 130 °C.

6. The method according to any of the preceding claims, **characterized in that** application of the electric field is obtained by connecting said layer of conductive or non-conductive material and connecting the glassy matrix to an electrical voltage source, by means of a first and second electrode respectively.

7. The method according to claim 6, **characterized in that** doping is N-type doping, and **in that** the electrical potential applied to the second electrode is positive in relation to the potential of the first electrode.

8. The method according to claim 6, **characterized in that** doping is P-type doping, and **in that** the electrical potential applied to the second electrode is negative in relation to the potential of the first electrode.
